# EUROPEAN PATENT SPECIFICATION

(11) **EP 3 089 224 B1**
(45) Date of publication and mention of the grant of the patent: **12.12.2018**
(21) Application number: 14882321.4
(22) Date of filing: 12.02.2014
(51) Int. Cl.: H01L 31/107, H01L 31/0232, H01L 31/0352, H01L 31/028, G02B 6/42, G02B 6/12

(54) **WAVEGUIDE-COUPLED AVALANCHE PHOTODIODE AND MANUFACTURING METHOD THEREFOR**
WELLENLEITER-GEKOPPELTE LAWINENFOTODIODE UND HERSTELLUNGSVERFAHREN DAFÜR
PHOTODIODE À AVALANCHE COUPLÉ À UN GUIDE D'ONDES ET SON PROCÉDÉ DE FABRICATION

(43) Date of publication of application: 02.11.2016
(73) Proprietor: Huawei Technologies Co., Ltd., Longgang District Shenzhen, Guangdong 518129 (CN)
(72) Inventor: YU, Changliang, Shenzhen Guangdong 518129 (CN); LIAO, Zhenxing, Shenzhen Guangdong 518129 (CN); ZHAO, Yanli, Wuhan Hubei 430074 (CN)
(74) Representative: Epping - Hermann - Fischer
(86) International application number: PCT/CN2014/071987
(87) International publication number: WO 2015/120583

(56) References cited:
- WO-A1-2011/083657
- WO-A1-2013/101110
- CN-A- 101 490 856
- CN-A- 102 916 071
- CN-A- 103 262 264
- JP-A- 2001 127 336
- US-A1- 2013 292 741
- ALAN P. MORRISON ET AL: "Progress towards photon counting between 1 µm and 1.6 µm using silicon with infrared absorbers", PROCEEDINGS OF SPIE, vol. 7681, 21 April 2010 (2010-04-21), pages 76810N-1, XP055140000, ISSN: 0277-786X, DOI: 10.1117/12.851875
- ZHIHONG HUANG ET AL: "Effectiveness of SiGe Buffer Layers in Reducing Dark Currents of Ge-on-Si Photodetectors", IEEE JOURNAL OF QUANTUM ELECTRONICS, IEEE SERVICE CENTER, PISCATAWAY, NJ, USA, vol. 43, no. 3, 1 March 2007 (2007-03-01), pages 238-242, XP011163547, ISSN: 0018-9197, DOI: 10.1109/JQE.2006.890395
- DONGHWAN AHN ET AL: "Evanescent Coupling Device Design for Waveguide-Integrated Group IV Photodetectors", JOURNAL OF LIGHTWAVE TECHNOLOGY, IEEE SERVICE CENTER, NEW YORK, NY, US, vol. 28, no. 23, 1 December 2010 (2010-12-01), pages 3387-3394, XP011339957, ISSN: 0733-8724, DOI: 10.1109/JLT.2010.2086433
- JIFENG LIU: "Monolithically Integrated Ge-on-Si Active Photonics", PHOTONICS, vol. 1, no. 3, 2 July 2014 (2014-07-02), pages 162-197, XP055353773, DOI: 10.3390/photonics1030162

## Description

### TECHNICAL FIELD

The present invention relates to the field of communications, and in particular, to an avalanche photodiode and a manufacturing method thereof.

### BACKGROUND

With increasing commercialization of 10 gigabit passive optical network (lOG-PONs) and increasing maturity of a next-generation passive optical network (PON) technology, a high-speed optical module raises increasingly urgent requirements for a high responsivity (which may also be referred to as high flexibility), high-bandwidth photodetector. Although a high-speed positive-intrinsic-negative (PIN) detector may have a very high speed and relatively low costs, responsivity of the high-speed PIN detector is also relatively low; therefore, it is difficult to meet a requirement of a high-speed PON network for flexibility and a power budget. An APD (Avalanche Photodiode, avalanche photodiode) may have very high responsivity due to a multiplication effect, and therefore becomes a preferred high-speed optical module.

Currently, a 10 Gbps APD is costly, and the APD has a relatively strong dark current, limiting flexibility of the APD.

CN 102 916 071 A discloses a photodiode and a manufacturing method thereof, relating to the field of opto-electrical technology, wherein the photodiode is capable of reducing the energy loss. The photodiode comprises a substrate positioned on a bottom layer, a lower cladding layer boss covering the substrate, an incident wave core guiding layer covering the lower cladding layer boss, an upper cladding layer covering the incident wave core guiding layer, an optical matching layer positioned above the upper cladding layer and an avalanche photodiode positioned above the middle part of the back end of the optical matching layer, wherein the width of the lower cladding layer boss at the tail end in the incident wave direction is wider than that of the beginning end in the incident wave direction, both sides of the lower cladding layer boss at the tail end in the incident wave direction are parallel, and both sides of the lower cladding layer boss at the beginning end in the incident wave direction are parallel; and the optical matching layer comprises an optical matching layer front end and an optical matching layer back end, wherein the optical matching layer front end comprises at least one air seam extended along the incident wave direction, and the optical matching layer front end is divided into characteristic units partitioned by the air seams. The embodiment of the invention is applied to manufacturing the photodiode.

The article "Progress towards photon counting between 1µm and 1.6µm using silicon with infrared absorbers" by A. Morrison et al., Proceedings of the SPIE, Vol. 7681, April 2010, describes one approach that allows the performance of silicon based Geigermode avalanche photodiodes (GM-APDs) to be extended into the near-infra-red. The process development is described whereby Ge absorbers are incorporated into adapted silicon APD designs to provide separate absorption and multiplication devices. Simulation results are presented outlining the performance of these devices at wavelengths between 1 µm and 1.6 µm. The performance results from silicon APD designs are presented for visible wavelengths. A silicon-germanium bonding process is described and the challenges presented in developing the hybrid absorber/multiplier structure are detailed. Finally, a summary of appropriate custom application integrated circuits for various applications is discussed.

The article "Effectiveness of SiGe Buffer Layers in Reducing Dark Currents of Ge-on-Si Photodetectors" by Z. Huang et al., IEEE Journal of Quantum Electronics, Vol. 43, March 2007 investigates the effectiveness of thin SiGe buffer layers in terminating threading dislocations and reducing photodiode dark current for Ge epitaxially grown on Si (001). The structural morphology of the films was studied by atomic force microscopy and transmission electron microscopy. The dark current of Ge on Si photodiodes can be reduced by over an order of magnitude by incorporating two different composition SiGe buffer layers. The origin of dark current and the effectiveness of thermal annealing the SiGe layers were also studied. The article "Evanescent Coupling Device Design for Waveguide-Integrated Group IV Photodetectors" by D. Ahn et al., Journal of Lightwave Technology, Vol. 28, December 2010, discloses that vertical p-i-n silicon photodetectors that are monolithically integrated with compact silicon-oxynitride channel waveguides have been fabricated. By comparing the evanescent coupling from low index-contrast waveguides and compact, high index-contrast waveguides, the dependence of evanescent coupling behavior on the waveguide index and geometry designs was analyzed. The effects of fabrication variations in the coupling structure have been studied and it was found that an offsetting step in the waveguide can help compensate for the mode mismatch at the transition interface from the input bus waveguide to the waveguide on top of the photodetector. Finally, a design map is presented, built by drawing the evanescent coupling rate contour lines in the waveguide design space, which well predicts the evanescent coupling trends.

### SUMMARY

The present invention provides an avalanche photodiode and a manufacturing method thereof, which can resolve problems in the prior art that an APD has a relatively strong dark current and is costly.

To achieve the foregoing objective, the invention provides an avalanche photodiode and an avalanche photodiode manufacturing method as defined in the attached claims.

According to the avalanche photodiode and the manufacturing method thereof provided by the claimed invention, a SiGe optical buffer layer of a proper thickness is added between a Si layer and an intrinsic Ge layer, and a Ge composition in the SiGe layer is controlled to be less than or equal to 20%, which not only significantly alleviate a problem of a lattice mismatch between the Si layer and the intrinsic Ge layer and greatly reduce a dark current of a SiGe avalanche photodiode, but also scarcely affect other performance such as quantum efficiency and a gain bandwidth product of the SiGe avalanche photodiode. In addition, an evanescent wave coupling structure is used, so as to avoid a problem of a declined component rate caused by a relatively thick SiGe buffer layer that is required when a common manner of coupling front normally incident light is used.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings and the following description show merely some embodiments of the present invention, and a person of ordinary skill in the art may still derive other drawings from these accompanying drawings without creative efforts.
FIG. 1 is a schematic structural diagram of an avalanche photodiode according to an embodiment of the present invention;
FIG. 2 is a schematic sectional diagram of an avalanche photodiode according to an embodiment of the present invention; and
FIG. 3 is a flowchart of an avalanche photodiode manufacturing method according to an embodiment of the present invention.

### DESCRIPTION OF EMBODIMENTS

The following clearly and completely describes the technical solutions in the embodiments of the present invention with reference to the accompanying drawings. Apparently, the described embodiments are merely some but not all of the embodiments of the present invention.

### Embodiment 1

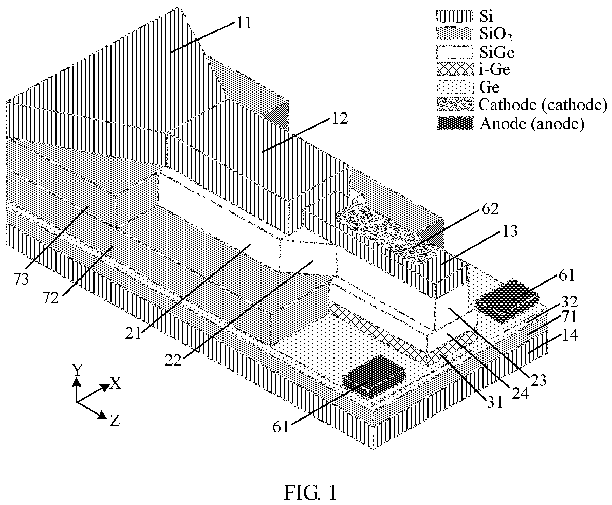

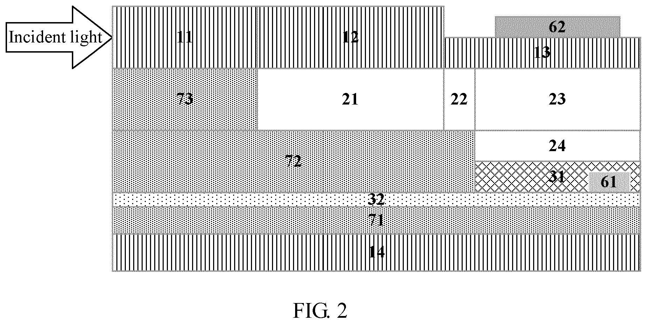

This embodiment of the present invention provides an avalanche photodiode. FIG. 1 is a schematic structural diagram of the avalanche photodiode, where a Z axis is a lightwave transmission direction, a Y axis is a height direction of the component, and an X axis is a width direction of the component. FIG. 2 is a schematic sectional diagram of the avalanche photodiode. Referring to FIG. 1 and FIG. 2, the avalanche photodiode includes:
a Germanium-On-Insulator (GeOI) substrate, including a silicon (Silicon, Si) substrate layer 14, a silicon dioxide (SiO₂) layer 71, and a germanium (Ge) layer 32, where
an intrinsic-germanium (I-Ge) absorption layer 31 is disposed on the GeOI substrate and is configured to absorb an optical signal and generate a photo-generated carrier;
a second p-type (positive) silicon-germanium (SiGe) layer 24 is disposed on the I-Ge absorption layer 31, and a first p-type SiGe layer 23 is disposed on the second p-type SiGe layer 24, where a Ge content in the first p-type SiGe layer 23 and the second p-type SiGe layer 24 is less than or equal to 20%;
a first SiO₂ layer 72 is further disposed on the GeOI substrate, and a second SiO₂ layer 73 is disposed on the first SiO₂ layer 72;
a SiGe waveguide layer 21 and a Taper type SiGe waveguide layer 22 are disposed on the first SiO₂ layer 72, where a Ge content in either of the SiGe waveguide layers is less than or equal to 20%;
a Taper (" 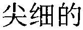 " in Chinese) type Si waveguide layer 11 and a Si waveguide layer 12 are further respectively disposed on the second SiO₂ layer 73 and the SiGe waveguide layer 21;
a heavily-doped negative (n-type) Si multiplication layer 13 is disposed on the Taper type SiGe waveguide layer 22 and the first p-type SiGe layer 23;
a cathode electrode 62 is disposed on the heavily-doped n-type Si multiplication layer 13; and
anode electrodes 61 are disposed on the GeOI substrate;
where the Taper type silicon waveguide layer 11, the silicon waveguide layer 12, the SiGe waveguide layer 21, and the Taper type SiGe waveguide layer 22 form an evanescent wave coupling structure;
the SiGe waveguide layer 21, the Taper type SiGe waveguide layer 22, the first p-type SiGe layer 23, and the second p-type SiGe layer 24 form a Taper type structure; and
the SiGe waveguide layer 21, the Taper type SiGe waveguide layer 22, the first p-type SiGe layer 23, the second p-type SiGe layer 24, and the I-Ge absorption layer 31 form an evanescent wave coupling structure.

Further, the first p-type SiGe layer 23 is used as a charge layer, an optical buffer layer, or an optical matching layer, and the second p-type SiGe layer 24 is used as an optical buffer layer or an optical matching layer.

The first p-type SiGe layer 23 and the second p-type SiGe layer 24 are configured to propagate optical signals at the SiGe waveguide layer 21 and the Taper type SiGe waveguide layer 22, and in addition, form an evanescent wave coupling structure together with the intrinsic-Ge absorption layer 31, to couple the optical signals to the intrinsic-Ge absorption layer 31, where the SiGe waveguide layer 21 and the Taper type SiGe waveguide layer 22 play roles of an optical matching layer and an optical buffer layer.

Further, the Taper type Si waveguide layer 11 and the Si waveguide layer 12 are configured to: perform butt-coupling with an optical fiber, act as optical active areas to receive incident optical signals, and form an evanescent wave coupling structure together with the SiGe waveguide layer 21 and the Taper type SiGe waveguide layer 22, to couple the incident optical signals to the SiGe waveguide layer 21 and the Taper type SiGe waveguide layer 22.

The heavily-doped n-type Si multiplication layer 13 is used in an area in which a collision ionization effect and a multiplication effect are generated.

A total thickness of the first p-type SiGe layer 23 and the second p-type SiGe layer 24 and a total thickness of the SiGe waveguide layer 21 and the Taper type SiGe waveguide layer 22 are different and respectively match a thickness of the intrinsic-Ge absorption layer 31, and a thickness of the Taper type Si waveguide layer 11 or the Si waveguide layer 12, so as to optimize coupling efficiency and quantum efficiency.

Further, structural parameters of the APD according to this embodiment of the present invention are shown in Table 1:

**Table 1 Structural parameters of an avalanche photodiode**

| **Name of a structural layer** | **Material** | **Width (µm)** | **Length (µm)** | **Thickness (µm)** |
|---|---|---|---|---|
| Taper type Si waveguide layer 11 | Si | Decrease from 1.9-48 µm to 1.2-28 µm | 2-50 | 0.07-35 |
| Si waveguide layer 12 | Si | 1.2-28 | 10-500 | 0.07-35 |
| Heavily-doped n-type Si multiplication layer 13 | Si | 1-20 | 5-250 | 0.05-2.5 |
| Silicon-germanium (SiGe) waveguide layer 21 | SiGe alloy, where a Ge content is less than or equal to 20% | 1.4-30 | 10-500 | 0.02-2.7 |
| Taper type silicon-germanium (SiGe) waveguide layer 22 | SiGe alloy, where a Ge content is less than or equal to 20% | Decrease from 1.4-30 µm to 1-20 µm | 1-20 | 0.02-2.7 |
| First p-type silicon-germanium (SiGe) layer 23 | P-type SiGe alloy, where a Ge content is less than or equal to 20% | 1-20 | 4-230 | 0.02-2.7 |
| Second p-type silicon-germanium (SiGe) layer 24 | P-type SiGe alloy, where a Ge content is less than or equal to 20% | 1.1-22 | 4-230 | 0.005-1 |
| Intrinsic-germanium (I-Ge) absorption layer 31 | I-Ge | 1.1-22 | 4-230 | 0.04-4 |
| Layers 14, 71, and 32 of the Germanium-on-insulator (GeOI) substrate | Si for the layer 14, SiO₂ for the layer 71, and Ge for the layer 32 | \ | \ | \ |

According to this embodiment of the present invention, a SiGe optical buffer layer of a proper thickness is added between a Si layer and a Ge layer, and a Ge composition in the SiGe layer is controlled to be less than or equal to 20%, which not only significantly alleviate a problem of a lattice mismatch between the Si layer and the Ge layer and greatly reduce a dark current of a SiGe avalanche photodiode, but also scarcely affect other performance such as quantum efficiency and a gain bandwidth product of the SiGe avalanche photodiode. In addition, an evanescent wave coupling structure is used, so as to avoid a problem of a declined component rate caused by a relatively thick SiGe buffer layer that is required when a common manner of coupling front normally incident light is used.

### Embodiment 2

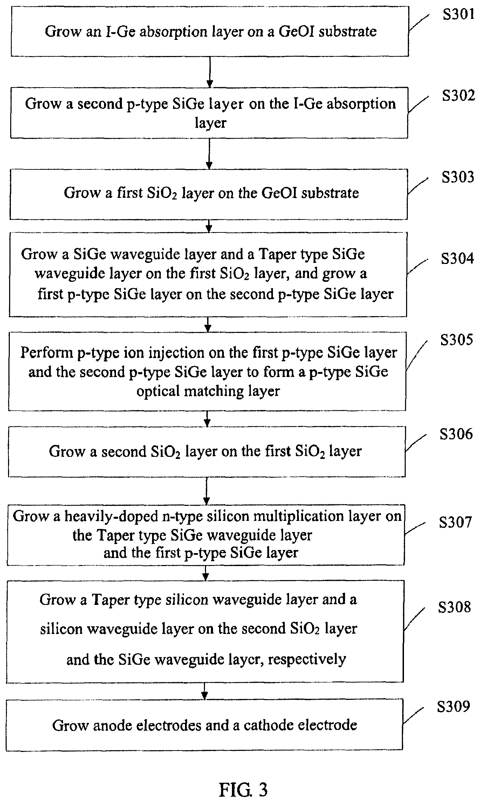

Based on the embodiment corresponding to FIG. 1, another embodiment of the present invention provides an avalanche photodiode manufacturing method. FIG. 3 is a schematic flowchart of the avalanche photodiode manufacturing method, as shown in FIG. 3:
S301: Epitaxially grow an I-Ge absorption layer 31 on a GeOI substrate.

Optionally, the GeOI substrate includes a Si substrate layer 14, a SiO₂ layer 71, and a Ge layer 32.

S302: Grow a second p-type SiGe layer 24 on the I-Ge absorption layer 31.

S303: Grow a first SiO₂ layer 72 on the GeOI substrate.

S304: Grow, on the first SiO₂ layer 72, a Taper waveguide including a SiGe waveguide layer 21 and a Taper type SiGe waveguide layer 22, and grow a first p-type SiGe layer 23 on the second p-type SiGe layer 24.

S305: Perform p-type ion injection on the first p-type SiGe layer 23 and the second p-type SiGe layer 24 to form a p-type SiGe optical matching layer.

S306: Grow a second Si02 layer 73 on the first SiO₂ layer 72.

S307: Grow a heavily-doped n-type Si multiplication layer 13 on the Taper type SiGe waveguide layer 22 and the first p-type SiGe layer 23.

S308: Grow a Taper type Si waveguide layer 11 and a Si waveguide layer 12 on the second SiO₂ layer 73 and the SiGe waveguide layer 21, respectively.

S309: Grow anode electrodes 61 on the GeOI substrate, and grow a cathode electrode 62 on the heavily-doped n-type Si multiplication layer 13.

Structural parameters of the avalanche photodiode are shown in Table 1 above.

According to the avalanche photodiode manufacturing method provided by this embodiment, a SiGe optical buffer layer/optical matching layer of a proper thickness is added between a Si layer and a Ge layer, and a Ge composition in the SiGe layer is controlled to be less than or equal to 20%, which not only significantly alleviate a problem of a lattice mismatch between the Si layer and the Ge layer and greatly reduce a dark current of a SiGe avalanche photodiode, but also scarcely affect other performance such as quantum efficiency and a gain bandwidth product of the SiGe avalanche photodiode. In addition, an evanescent wave coupling structure is used, so as to avoid a problem of a declined component rate caused by a relatively thick SiGe buffer layer that is required when a common manner of coupling front normally incident light is used.

The foregoing descriptions are merely specific implementation manners of the present invention, but are not intended to limit the protection scope of the present invention. The protection scope of the present invention shall be subject to the protection scope of the claims.

## Claims

1. An avalanche photodiode, comprising:
a germanium-on-insulator, GeOI, substrate, wherein:
an intrinsic-germanium, I-Ge, absorption layer (31) is disposed on the GeOI substrate for the absorption of an optical signal and the generation of photo-generated carriers;
a second p-type silicon-germanium, SiGe, layer (24) is disposed on the I-Ge absorption layer (31), and a first p-type SiGe layer (23) is disposed on the second p-type SiGe layer (24), wherein a germanium, Ge, content in the first p-type SiGe layer (23) and the second p-type SiGe layer (24) is less than or equal to 20%;
a first silicon dioxide, SiO₂, layer (72) is further disposed on the GeOI substrate, and a second SiO₂ layer (73) is disposed on the first SiO₂ layer (72);
a SiGe waveguide layer (21) and a Taper type SiGe waveguide layer (22) are disposed on the first SiO₂ layer (72), wherein a Ge content in either of the SiGe waveguide layers is less than or equal to 20%;
a Taper type silicon, Si, waveguide layer (11) and a Si waveguide layer (12) are further respectively disposed on the second SiO₂ layer (73) and the SiGe waveguide layer (21);
a heavily-doped n-type Si multiplication layer (13) is disposed on the Taper type SiGe waveguide layer (22) and the first p-type SiGe layer (23);
a cathode electrode (62) is disposed on the heavily-doped n-type Si multiplication layer (13); and
anode electrodes (61) are disposed on the GeOI substrate;
wherein the Taper type Si waveguide layer (11), the Si waveguide layer (12), the SiGe waveguide layer (21), and the Taper type SiGe waveguide layer (22) form an evanescent wave coupling structure;
the SiGe waveguide layer (21), the Taper type SiGe waveguide layer (22), the first p-type SiGe layer (23), and the second p-type SiGe layer (24) form a Taper type structure, wherein the SiGe waveguide layer (21), the Taper type SiGe waveguide layer (22), and the first p-type SiGe layer (23) are arranged in the same plane and have the same thickness, a width of the Taper type SiGe waveguide layer (22) decreases from the width of the SiGe waveguide layer (21) to the width of the first p-type SiGe layer (23); and the length of the first p-type SiGe layer (23) disposed on the second p-type SiGe layer (24) corresponds to the length of the second p-type SiGe layer (24); and
the SiGe waveguide layer (21), the Taper type SiGe waveguide layer (22), the first p-type SiGe layer (23), the second p-type SiGe layer (24), and the I-Ge absorption layer (31) form an evanescent wave coupling structure.

2. The avalanche photodiode according to claim 1, wherein the thickness of the SiGe waveguide layer (21), the Taper type SiGe waveguide layer (22) and the first p-type SiGe layer (23) lies in the range of 0.02 to 2.7 micrometers, and the total thickness of the second p-type SiGe layer (24) and the I-Ge absorption layer (31) corresponds to the thickness of the first SiO₂ layer (72), wherein the thickness of the second p-type SiGe layer (24) lies in the range of 0.005 to 1 micrometers and the thickness of the I-Ge absorption layer (31) lies in the range of 0.04 to 4 micrometers.

3. The avalanche photodiode according to claim 1 or 2, wherein a width range of the SiGe waveguide layer (21) is 1.4 micrometers to 30 micrometers, a length range of the SiGe waveguide layer (21) is 10 micrometers to 500 micrometers, and a thickness range of the SiGe waveguide layer (21) is 0.02 micrometer to 2.7 micrometers.

4. The avalanche photodiode according to any one of claims 1 to 3, wherein a width range of the Taper type SiGe waveguide layer (22) progressively decreases from 1.4 micrometers to 30 micrometers to 1 micrometer to 20 micrometers, a length range of the Taper type SiGe waveguide layer (22) is 1 micrometer to 20 micrometers, and a thickness range of the Taper type SiGe waveguide layer (22) is 0.02 micrometer to 2.7 micrometers.

5. The avalanche photodiode according to any one of claims 1 to 4, wherein a width range of the first p-type SiGe layer (23) is 1 micrometer to 20 micrometers, a length range of the first p-type SiGe layer (23) is 4 micrometers to 230 micrometers, and a thickness range of the first p-type SiGe layer (23) is 0.02 micrometer to 2.7 micrometers.

6. The avalanche photodiode according to any one of claims 1 to 5, wherein a width range of the second p-type SiGe layer (24) is 1.1 micrometers to 22 micrometers, a length range of the second p-type SiGe layer (24) is 4 micrometers to 230 micrometers, and a thickness range of the second p-type SiGe layer (24) is 0.005 micrometer to 1 micrometer.

7. An avalanche photodiode manufacturing method, comprising:
epitaxially growing an intrinsic-germanium, I-Ge, absorption layer (31) on a germanium-on-insulator, GeOI, substrate;
growing a second p-type silicon-germanium, SiGe, layer (24) on the I-Ge absorption layer (31);
growing a first silicon dioxide, SiO₂, layer (72) on the GeOI substrate;
growing, on the first SiO₂ layer (72), a SiGe waveguide layer (21) and a Taper type SiGe waveguide layer (22);
growing a first p-type SiGe layer (23) on the second p-type SiGe layer (24), wherein a germanium, Ge, content in the first p-type SiGe layer (23) and the second p-type SiGe layer (24) is less than or equal to 20%, and wherein the SiGe waveguide layer (21), the Taper type SiGe waveguide layer (22), and the first p-type SiGe layer (23) are arranged in the same plane and have the same thickness, a width of the Taper type SiGe waveguide layer (22) decreases from the width of the SiGe waveguide layer (21) to the width of the first p-type SiGe layer (23); and the length of the first p-type SiGe layer (23) disposed on the second p-type SiGe layer (24) corresponds to the length of the second p-type SiGe layer (24);
performing p-type ion injection on the first p-type SiGe layer (23) and the second p-type SiGe layer (24) to form a p-type SiGe optical matching layer;
growing a second SiO₂ layer (73) on the first SiO₂ layer (72);
growing a heavily-doped n-type silicon, Si, multiplication layer (13) on the Taper type SiGe waveguide layer (22) and the first p-type SiGe layer (23);
growing a Taper type Si waveguide layer (11) and a Si waveguide layer (12) on the second SiO₂ layer (73) and the SiGe waveguide layer (21), respectively, wherein the Taper type Si waveguide layer (11), the Si waveguide layer (12), the SiGe waveguide layer (21), and the Taper type SiGe waveguide layer (22) form an evanescent wave coupling structure, and wherein the SiGe waveguide layer (21), the Taper type SiGe waveguide layer (22), the first p-type SiGe layer (23), the second p-type SiGe layer (24), and the I-Ge absorption layer (31) form an evanescent wave coupling structure;
growing anode electrodes (61) on the GeOI substrate; and
growing a cathode electrode (62) on the heavily-doped n-type Si multiplication layer (13).

8. The avalanche photodiode manufacturing method according to claim 7, wherein a width range of the SiGe waveguide layer (21) is 1.4 micrometers to 30 micrometers, a length range of the SiGe waveguide layer (21) is 10 micrometers to 500 micrometers, and a thickness range of the SiGe waveguide layer (21) is 0.02 micrometer to 2.7 micrometers.

9. The avalanche photodiode manufacturing method according to claim 7 or 8, wherein a width range of the Taper type SiGe waveguide layer (22) progressively decreases from 1.4 micrometers to 30 micrometers to 1 micrometer to 20 micrometers, a length range of the Taper type SiGe waveguide layer (22) is 1 micrometer to 20 micrometers, and a thickness range of the Taper type SiGe waveguide layer (22) is 0.02 micrometer to 2.7 micrometers.

10. The avalanche photodiode manufacturing method according to any one of claims 7 to 9, wherein a width range of the first p-type SiGe layer (23) is 1 micrometer to 20 micrometers, a length range of the first p-type SiGe layer (23) is 4 micrometers to 230 micrometers, and a thickness range of the first p-type SiGe layer (23) is 0.02 micrometer to 2.7 micrometers.

11. The avalanche photodiode manufacturing method according to any one of claims 7 to 10, wherein a width range of the second p-type SiGe layer (24) is 1.1 micrometers to 22 micrometers, a length range of the second p-type SiGe layer (24) is 4 micrometers to 230 micrometers, and a thickness range of the second p-type SiGe layer (24) is 0.005 micrometer to 1 micrometer.

## Patentansprüche

1. Lawinenphotodiode, die Folgendes umfasst:
ein Germanium-auf-Isolator- bzw. GeOI-Substrat, wobei:
eine Intrinsisches-Germanium- bzw. I-Ge-Absorptionsschicht (31) auf dem GeOI-Substrat für die Absorption eines optischen Signals und die Erzeugung photogenerierter Ladungsträger angeordnet ist;
eine zweite p-Typ-Silicium-Germanium- bzw. -SiGe-Schicht (24) auf der I-Ge-Absorptionsschicht (31) angeordnet ist und eine erste p-Typ-SiGe-Schicht (23) auf der zweiten p-Typ-SiGe-Schicht (24) angeordnet ist, wobei ein Germanium- bzw. Ge-Anteil in der ersten p-Typ-SiGe-Schicht (23) und der zweiten p-Typ-SiGe-Schicht (24) geringer als oder gleich 20 % ist;
eine erste Siliciumdioxid- bzw. SiO₂-Schicht (72) ferner auf dem GeOI-Substrat angeordnet ist und eine zweite SiO₂-Schicht (73) auf der ersten Si02-Schicht (72) angeordnet ist;
eine SiGe-Wellenleiterschicht (21) und eine SiGe-Wellenleiterschicht (22) vom sich verjüngenden Typ auf der ersten SiO₂-Schicht (72) angeordnet sind, wobei ein Ge-Anteil in beiden der SiGe-Wellenleiterschichten kleiner als oder gleich 20 % ist;
eine Silicium- bzw. Si-Wellenleiterschicht (11) vom sich verjüngenden Typ und eine Si-Wellenleiterschicht (12) ferner auf der zweiten SiO₂-Schicht (73) bzw. der SiGe-Wellenleiterschicht (21) angeordnet sind;
eine stark dotierte n-Typ-Si-Multiplikationsschicht (13) auf der SiGe-Wellenleiterschicht (22) vom sich verjüngenden Typ und der ersten p-Typ-SiGe-Schicht (23) angeordnet sind;
eine Kathodenelektrode (62) auf der stark dotierten n-Typ-Si-Multiplikationsschicht (13) angeordnet ist; und
Anodenelektroden (61) auf dem GeOI-Substrat angeordnet sind;
wobei die Si-Wellenleiterschicht (11) vom sich verjüngenden Typ, die Si-Wellenleiterschicht (12), die SiGe-Wellenleiterschicht (21) und die SiGe-Wellenleiterschicht (22) vom sich verjüngenden Typ eine Evaneszente-Welle-Kopplungsstruktur bilden;
die SiGe-Wellenleiterschicht (21), die SiGe-Wellenleiterschicht (22) vom sich verjüngenden Typ, die erste p-Typ-SiGe-Schicht (23) und die zweite p-Typ-SiGe-Schicht (24) eine Struktur vom sich verjüngenden Typ bilden, wobei die SiGe-Wellenleiterschicht (21), die SiGe-Wellenleiterschicht (22) vom sich verjüngenden Typ und die erste p-Typ-SiGe-Schicht (23) in derselben Ebene angeordnet sind und die gleiche Dicke aufweisen, eine Breite der SiGe-Wellenleiterschicht (22) vom sich verjüngenden Typ von der Breite der SiGe-Wellenleiterschicht (21) zu der Breite der ersten p-Typ-SiGe-Schicht (23) abnimmt; und die Länge der ersten p-Typ-SiGe-Schicht (23), die auf der zweiten p-Typ-SiGe-Schicht (24) angeordnet ist, der Länge der zweiten p-Typ-SiGe-Schicht (24) entspricht; und
die SiGe-Wellenleiterschicht (21), die SiGe-Wellenleiterschicht (22) vom sich verjüngenden Typ, die erste p-Typ-SiGe-Schicht (23), die zweite p-Typ-SiGe-Schicht (24) und die I-Ge-Absorptionsschicht (31) eine Evaneszente-Welle-Kopplungsstruktur bilden.

2. Lawinenphotodiode nach Anspruch 1, wobei die Dicke der SiGe-Wellenleiterschicht (21), der SiGe-Wellenleiterschicht (22) vom sich verjüngenden Typ und der ersten p-Typ-SiGe-Schicht (23) in dem Bereich von 0,02 bis 2,7 Mikrometer liegt und die gesamte Dicke der zweiten p-Typ-SiGe-Schicht (24) und der I-Ge-Absorptionsschicht (31) der Dicke der ersten SiO₂-Schicht (72) entspricht, wobei die Dicke der zweiten p-Typ-SiGe-Schicht (24) in dem Bereich von 0,005 bis 1 Mikrometer liegt und die Dicke der I-Ge-Absorptionsschicht (31) in dem Bereich von 0,04 bis 4 Mikrometer liegt.

3. Lawinenphotodiode nach Anspruch 1 oder 2, wobei ein Breitenbereich der SiGe-Wellenleiterschicht (21) 1,4 Mikrometer bis 30 Mikrometer ist, ein Längenbereich der SiGe-Wellenleiterschicht (21) 10 bis 500 Mikrometer ist und ein Dickenbereich der SiGe-Wellenleiterschicht (21) 0,02 Mikrometer bis 2,7 Mikrometer ist.

4. Lawinenphotodiode nach einem der Ansprüche 1 bis 3, wobei ein Breitenbereich der SiGe-Wellenleiterschicht (22) vom sich verjüngenden Typ progressiv von 1,4 Mikrometer bis 30 Mikrometer zu 1 Mikrometer bis 20 Mikrometer abnimmt, ein Längenbereich der SiGe-Wellenleiterschicht (22) vom sich verjüngenden Typ 1 Mikrometer bis 20 Mikrometer ist und ein Dickenbereich der SiGe-Wellenleiterschicht (22) vom sich verjüngenden Typ 0,02 Mikrometer bis 2.7 Mikrometer ist.

5. Lawinenphotodiode nach einem der Ansprüche 1 bis 4, wobei ein Breitenbereich der ersten p-Typ-SiGe-Schicht (23) 1 Mikrometer bis 20 Mikrometer ist, ein Längenbereich der ersten p-Typ-SiGe-Schicht (23) 4 Mikrometer bis 230 Mikrometer ist und ein Dickenbereich der ersten p-Typ-SiGe-Schicht (23) 0,02 Mikrometer bis 2,7 Mikrometer ist.

6. Lawinenphotodiode nach einem der Ansprüche 1 bis 5, wobei ein Breitenbereich der zweiten p-Typ-SiGe-Schicht (24) 1,1 Mikrometer bis 22 Mikrometer ist, ein Längenbereich der zweiten p-Typ-SiGe-Schicht (24) 4 Mikrometer bis 230 Mikrometer ist und ein Dickenbereich der zweiten p-Typ-SiGe-Schicht (24) 0,005 Mikrometer bis 1 Mikrometer ist.

7. Lawinenphotodiodenherstellungsverfahren, das Folgendes umfasst:
epitaktisches Aufwachsen einer Intrinsisches-Germanium- bzw. I-Ge-Absorptionsschicht (31) auf einem Germanium-auf-Isolator- bzw. GeOI-Substrat;
Aufwachsen einer zweiten p-Typ-Silicium-Germanium- bzw. -SiGe-Schicht (24) auf der I-Ge-Absorptionsschicht (31);
Aufwachsen einer ersten Siliciumdioxid- bzw. SiO₂-Schicht (72) auf dem GeOI-Substrat;
Aufwachsen einer SiGe-Wellenleiterschicht (21) und einer SiGe-Wellenleiterschicht (22) vom sich verjüngenden Typ auf der ersten SiO₂-Schicht (72);
Aufwachsen einer ersten p-Typ-SiGe-Schicht (23) auf der zweiten p-Typ-SiGe-Schicht (24), wobei ein Germanium- bzw. Ge-Anteil in der ersten p-Typ-SiGe-Schicht (23) und der zweiten p-Typ-SiGe-Schicht (24) geringer als oder gleich 20 % ist, und wobei die SiGe-Wellenleiterschicht (21), die SiGe-Wellenleiterschicht (22) vom sich verjüngenden Typ und die erste p-Typ-SiGe-Schicht (23) in derselben Ebene angeordnet sind und die gleiche Dicke aufweisen, eine Breite der SiGe-Wellenleiterschicht (22) vom sich verjüngenden Typ von der Breite der SiGe-Wellenleiterschicht (21) zu der Breite der ersten p-Typ-SiGe-Schicht (23) abnimmt;
und die Länge der ersten p-Typ-SiGe-Schicht (23), die auf der zweiten p-Typ-SiGe-Schicht (24) angeordnet ist, der Länge der zweiten p-Typ-SiGe-Schicht (24) entspricht;
Durchführen einer p-Typ-Ionen-Injektion an der ersten p-Typ-SiGe-Schicht (23) und der zweiten p-Typ-SiGe-Schicht (24), um eine p-Typ-SiGe-Optikanpassungsschicht zu bilden;
Aufwachsen einer zweiten SiO₂-Schicht (73) auf der ersten SiO₂-Schicht (72);
Aufwachsen einer stark dotierten n-Typ-Silicium- bzw. -Si-Multiplikationsschicht (13) auf der SiGe-Wellenleiterschicht (22) vom sich verjüngenden Typ und der ersten p-Typ-SiGe-Schicht (23);
Aufwachsen einer Si-Wellenleiterschicht (11) vom sich verjüngenden Typ und einer Si-Wellenleiterschicht (12) auf der zweiten SiO₂-Schicht (73) bzw. der SiGe-Wellenleiterschicht (21), wobei die Si-Wellenleiterschicht (11) vom sich verjüngenden Typ, die Si-Wellenleiterschicht (12), die SiGe-Wellenleiterschicht (21) und die SiGe-Wellenleiterschicht (22) vom sich verjüngenden Typ eine Evaneszente-Welle-Kopplungsstruktur bilden und wobei die SiGe-Wellenleiterschicht (21), die SiGe-Wellenleiterschicht (22) vom sich verjüngenden Typ, die erste p-Typ-SiGe-Schicht (23), die zweite p-Typ-SiGe-Schicht (24) und die I-Ge-Absorptionsschicht (31) eine Evaneszente-Welle-Kopplungsstruktur bilden;
Aufwachsen von Anodenelektroden (61) auf dem GeOI-Substrat; und
Aufwachsen einer Kathodenelektrode (62) auf der stark dotierten n-Typ-Si-Multiplikationsschicht (13).

8. Lawinenphotodiodenherstellungsverfahren nach Anspruch 7, wobei ein Breitenbereich der SiGe-Wellenleiterschicht (21) 1,4 Mikrometer bis 30 Mikrometer ist, ein Längenbereich der SiGe-Wellenleiterschicht (21) 10 bis 500 Mikrometer ist und ein Dickenbereich der SiGe-Wellenleiterschicht (21) 0,02 Mikrometer bis 2,7 Mikrometer ist.

9. Lawinenphotodiodenherstellungsverfahren nach Anspruch 7 oder 8, wobei ein Breitenbereich der SiGe-Wellenleiterschicht (22) vom sich verjüngenden Typ progressiv von 1,4 Mikrometer bis 30 Mikrometer zu 1 Mikrometer bis 20 Mikrometer abnimmt, ein Längenbereich der SiGe-Wellenleiterschicht (22) vom sich verjüngenden Typ 1 Mikrometer bis 20 Mikrometer ist und ein Dickenbereich der SiGe-Wellenleiterschicht (22) vom sich verjüngenden Typ 0,02 Mikrometer bis 2.7 Mikrometer ist.

10. Lawinenphotodiodenherstellungsverfahren nach einem der Ansprüche 7 bis 9, wobei ein Breitenbereich der ersten p-Typ-SiGe-Schicht (23) 1 Mikrometer bis 20 Mikrometer ist, ein Längenbereich der ersten p-Typ-SiGe-Schicht (23) 4 Mikrometer bis 230 Mikrometer ist und ein Dickenbereich der ersten p-Typ-SiGe-Schicht (23) 0,02 Mikrometer bis 2,7 Mikrometer ist.

11. Lawinenphotodiodenherstellungsverfahren nach einem der Ansprüche 7 bis 10, wobei ein Breitenbereich der zweiten p-Typ-SiGe-Schicht (24) 1,1 Mikrometer bis 22 Mikrometer ist, ein Längenbereich der zweiten p-Typ-SiGe-Schicht (24) 4 Mikrometer bis 230 Mikrometer ist und ein Dickenbereich der zweiten p-Typ-SiGe-Schicht (24) 0,005 Mikrometer bis 1 Mikrometer ist.

## Revendications

1. Photodiode à avalanche, comprenant :
un substrat de germanium sur isolant, GeOI, dans laquelle :
une couche d'absorption (31) de germanium intrinsèque, I-Ge, est disposée sur le substrat de GeOI pour l'absorption d'un signal optique et la génération de porteurs photo-générés ;
une seconde couche de silicium-germanium, SiGe, de type p (24) est disposée sur la couche d'absorption d'I-Ge (31), et une première couche de SiGe de type p (23) est disposée sur la seconde couche de SiGe de type p (24), dans laquelle une teneur en germanium, Ge, dans la première couche de SiGe de type p (23) et la seconde couche de SiGe de type p (24) est inférieure ou égale à 20 % ;
une première couche de dioxyde de silicium, SiO₂, (72) est en outre disposée sur le substrat de GeOI, et une seconde couche de SiO₂ (73) est disposée sur la première couche de SiO₂ (72) ;
une couche de guide d'ondes de SiGe (21) et une couche de guide d'ondes de SiGe de type raccord progressif (22) sont disposées sur la première couche de SiO₂ (72), dans laquelle une teneur en Ge dans l'une ou l'autre des couches de guide d'ondes de SiGe est inférieure ou égale à 20 % ;
une couche de guide d'ondes de silicium, Si, de type raccord progressif (11) et une couche de guide d'ondes de Si (12) sont en outre disposées respectivement sur la seconde couche de SiO₂ (73) et la couche de guide d'ondes de SiGe (21) ;
une couche de multiplication de Si de type n fortement dopée (13) est disposée sur la couche de guide d'ondes de SiGe de type raccord progressif (22) et la première couche de SiGe de type p (23) ;
une électrode de cathode (62) est disposée sur la couche de multiplication de Si de type n fortement dopée (13) ; et
des électrodes d'anode (61) sont disposées sur le substrat de GeOI ;
dans laquelle la couche de guide d'ondes de Si de type raccord progressif (11), la couche de guide d'ondes de Si (12), la couche de guide d'ondes de SiGe (21), et la couche de guide d'ondes de SiGe de type raccord progressif (22) forment une structure de couplage d'ondes évanescentes ;
la couche de guide d'ondes de SiGe (21), la couche de guide d'ondes de SiGe de type raccord progressif (22), la première couche de SiGe de type p (23), et la seconde couche de SiGe de type p (24) forment une structure de type raccord progressif, dans laquelle la couche de guide d'ondes de SiGe (21), la couche de guide d'ondes de SiGe de type raccord progressif (22), et la première couche de SiGe de type p (23) sont agencées dans le même plan et ont la même épaisseur, une largeur de la couche de guide d'ondes de type raccord progressif (22) diminue de la largeur de la couche de guide d'ondes de SiGe (21) à la largeur de la première couche de SiGe de type p (23) ; et la longueur de la première couche de SiGe de type p (23) disposée sur la seconde couche de SiGe de type p (24) correspond à la longueur de la seconde couche de SiGe de type p (24) ; et
la couche de guide d'ondes de SiGe (21), la couche de guide d'ondes de SiGe de type raccord progressif (22), la première couche de SiGe de type p (23), la seconde couche de SiGe de type p (24), et la couche d'absorption d'I-Ge (31) forment une structure de couplage d'ondes évanescentes.

2. Photodiode à avalanche selon la revendication 1, dans laquelle l'épaisseur de la couche de guide d'ondes de SiGe (21), de la couche de guide d'ondes de SiGe de type raccord progressif (22) et de la première couche de SiGe de type p (23) est comprise entre 0,02 et 2,7 micromètres, et l'épaisseur totale de la seconde couche de SiGe de type p (24) et de la couche d'absorption d'I-Ge (31) correspond à l'épaisseur de la première couche de SiO₂ (72), dans laquelle l'épaisseur de la seconde couche de SiGe de type p (24) est comprise entre 0,005 et 1 micromètre et l'épaisseur de la couche d'absorption d'I-Ge (31) est comprise entre 0,04 et 4 micromètres.

3. Photodiode à avalanche selon la revendication 1 ou 2, dans laquelle une plage de largeur de la couche de guide d'ondes de SiGe (21) est de 1,4 micromètre à 30 micromètres, une plage de longueur de la couche de guide d'ondes de SiGe (21) est de 10 micromètres à 500 micromètres, et une plage d'épaisseur de la couche de guide d'ondes de SiGe (21) est de 0,02 micromètre à 2,7 micromètres.

4. Photodiode à avalanche selon l'une quelconque des revendications 1 à 3, dans laquelle une plage de largeur de la couche de guide d'ondes de SiGe de type raccord progressif (22) diminue progressivement de 1,4 micromètre à 30 micromètres à 1 micromètre à 20 micromètres, une plage de longueur de la couche de guide d'ondes de SiGe de type raccord progressif (22) est de 1 micromètre à 20 micromètres, et une plage d'épaisseur de la couche de guide d'ondes de SiGe de type raccord progressif (22) est de 0,02 micromètre à 2,7 micromètres.

5. Photodiode à avalanche selon l'une quelconque des revendications 1 à 4, dans laquelle une plage de largeur de la première couche de SiGe de type p (23) est de 1 micromètre à 20 micromètres, une plage de longueur de la première couche de SiGe de type p (23) est de 4 micromètres à 230 micromètres, et une plage d'épaisseur de la première couche de SiGe de type p (23) est de 0,02 micromètre à 2,7 micromètres.

6. Photodiode à avalanche selon l'une quelconque des revendications 1 à 5, dans laquelle une plage de largeur de la seconde couche de SiGe de type p (24) est de 1,1 micromètre à 22 micromètres, une plage de longueur de la seconde couche de SiGe de type p (24) est de 4 micromètres à 230 micromètres, et une plage d'épaisseur de la seconde couche de SiGe de type p (24) est de 0,005 micromètre à 1 micromètre.

7. Procédé de fabrication de photodiode à avalanche, comprenant de :
faire croître épitaxialement une couche d'absorption de germanium intrinsèque, I-Ge, (31) sur un substrat de germanium sur isolant, GeOI ;
faire croître une seconde couche de silicium-germanium, SiGe, de type p (24) sur la couche d'absorption d'I-Ge (31) ;
faire croître une première couche de dioxyde de silicium, SiO₂, (72) sur le substrat de GeOI;
faire croître, sur la première couche de SiO₂ (72), d'une couche de guide d'ondes de SiGe (21) et une couche de guide d'ondes de SiGe de type raccord progressif (22) ;
faire croître une première couche de SiGe de type p (23) sur la seconde couche de SiGe de type p (24), dans lequel une teneur en germanium, Ge, dans la première couche de SiGe de type p (23) et la seconde couche de SiGe de type p (24) est inférieure ou égale à 20 %, et dans lequel la couche de guide d'ondes de SiGe (21), la couche de guide d'ondes de SiGe de type raccord progressif (22), et la première couche de SiGe de type p (23) sont agencées dans le même plan et ont la même épaisseur, une largeur de la couche de guide d'ondes de SiGe de type raccord progressif (22) diminue de la largeur de la couche de guide d'ondes de SiGe (21) à la largeur de la première couche de SiGe de type p (23) ; et la longueur de la première couche de SiGe de type p (23) disposée sur la seconde couche de SiGe de type p (24) correspond à la longueur de la seconde couche de SiGe de type p (24) ;
effectuer une injection ionique de type p sur la première couche de SiGe de type p (23) et la seconde couche de SiGe de type p (24) pour former une couche d'adaptation optique de SiGe de type p ;
faire croître une seconde couche de SiO₂ (73) sur la première couche de SiO₂ (72) ;
faire croître une couche de multiplication de silicium, Si, de type n fortement dopée (13) sur la couche de guide d'ondes de SiGe de type raccord progressif (22) et la première couche de SiGe de type p (23) ;
faire croître une couche de guide d'ondes de Si de type raccord progressif (11) et une couche de guide d'ondes de Si (12) sur la seconde couche de SiO₂ (73) et la couche de guide d'ondes de SiGe (21), respectivement, dans lequel la couche de guide d'ondes de Si de type raccord progressif (11), la couche de guide d'ondes de Si (12), la couche de guide d'ondes de SiGe (21), et la couche de guide d'ondes de SiGe de type raccord progressif (22) forment une structure de couplage d'ondes évanescentes, et dans lequel la couche de guide d'ondes de SiGe (21), la couche de guide d'ondes de SiGe de type raccord progressif (22), la couche de SiGe de type p (23), la seconde couche de SiGe de type p (24), et la couche d'absorption d'I-Ge (31) forment une structure de couplage d'ondes évanescentes ;
faire croître des électrodes d'anode (61) sur le substrat de GeOI ; et
faire croître une électrode de cathode (62) sur la couche de multiplication de Si de type n fortement dopée (13).

8. Procédé de fabrication de photodiode à avalanche selon la revendication 7, dans lequel une plage de largeur de la couche de guide d'ondes de SiGe (21) est de 1,4 micromètre à 30 micromètres, une plage de longueur de la couche de guide d'ondes de SiGe (21) est de 10 micromètres à 500 micromètres, et une plage d'épaisseur de la couche de guide d'ondes de SiGe (21) est de 0,02 micromètre à 2,7 micromètres.

9. Procédé de fabrication de photodiode à avalanche selon la revendication 7 ou 8, dans lequel une plage de largeur de la couche de guide d'ondes de SiGe de type raccord progressif (22) diminue progressivement de 1,4 micromètre à 30 micromètres à 1 micromètre à 20 micromètres, une plage de longueur de la couche de guide d'ondes de SiGe de type raccord progressif (22) est de 1 micromètre à 20 micromètres, et une plage d'épaisseur de la couche de guide d'ondes de SiGe de type raccord progressif (22) est de 0,02 micromètre à 2,7 micromètres.

10. Procédé de fabrication de photodiode à avalanche selon l'une quelconque des revendications 7 à 9, dans lequel une plage de largeur de la première couche de SiGe de type p (23) est de 1 micromètre à 20 micromètres, une plage de longueur de la première couche de SiGe de type p (23) est de 4 micromètres à 230 micromètres, et une plage d'épaisseur de la première couche de SiGe de type p (23) est de 0,02 micromètre à 2,7 micromètres.

11. Procédé de fabrication de photodiode à avalanche selon l'une quelconque des revendications 7 à 10, dans laquelle une plage de largeur de la seconde couche de SiGe de type p (24) est de 1,1 micromètre à 22 micromètres, une plage de longueur de la seconde couche de SiGe de type p (24) est de 4 micromètres à 230 micromètres, et une plage d'épaisseur de la seconde couche de SiGe de type p (24) est de 0,005 micromètre à 1 micromètre.
